(19) Europäisches Patentamt
European Patent Office
Office européen des brevets

(11) **EP 0 518 785 B1**

(12) **FASCICULE DE BREVET EUROPEEN**

(45) Date de publication et mention
de la délivrance du brevet:
**31.07.1996   Bulletin 1996/31**

(51) Int Cl.⁶: **G01R 27/18**, H02H 3/17, G01R 25/00

(21) Numéro de dépôt: **92420159.3**

(22) Date de dépôt: **15.05.1992**

(54) **Dispositif de contrôle et de mesure d'isolement pour réseau électrique à neutre isolé**

Anordnung zur Überwachung und Messung der Isolierung für elektrische Netze mit isoliertem Nulleiter

Device for checking and measuring the insulation of a power line having an insulated neutral conductor

(84) Etats contractants désignés:
**BE CH DE ES GB IT LI SE**

(30) Priorité: **21.05.1991   FR 9106307**

(43) Date de publication de la demande:
**16.12.1992   Bulletin 1992/51**

(73) Titulaire: **SCHNEIDER ELECTRIC SA**
**F-92100 Boulogne-Billancourt (FR)**

(72) Inventeurs:
• **Allin, Patrice**
  **F-38050 Grenoble Cedex 9 (FR)**
• **Pellegrin, Christian**
  **F-38050 Grenoble Cedex 9 (FR)**
• **Weynachter, Luc**
  **F-38050 Grenoble Cedex 9 (FR)**

(74) Mandataire: **Hecké, Gérard**
**Schneider Electric SA,**
**Sce. Propriété Industrielle**
**38050 Grenoble Cédex 09 (FR)**

(56) Documents cités:
**EP-A- 0 035 365        EP-A- 0 166 839**
**EP-A- 0 398 824        EP-A- 0 399 923**
**FR-A- 1 443 140**

• **TECHNIQUES CEM. no. 107, Mars 1980, PARIS
FR pages 48 - 56; G. MACHESAN: 'LA
PROTECTION DES PERSONNES ET DES BIENS
CONTRE LES DANGERS DU COURANT
ELECTRIQUE'**

**Description**

La présente invention se rapporte à un dispositif de contrôle et de mesure d'isolement, plus couramment dénommé "contrôleur d'isolement", pour réseau électrique, tel qu'un réseau électrique alternatif monophasé ou triphasé, ce réseau électrique étant à neutre isolé de telle sorte que la ou les impédances de charge sont alors connectées entre une phase et ce neutre isolé, et non pas entre cette phase et la terre.

Un contrôleur d'isolement du type ci-dessus mentionné, et de l'art connu, est par exemple décrit dans le document FR-A-2.647.220 de la demanderesse duquel le preambule de la revendication 1 est dérivé.

Un tel dispositif fonctionne de la façon suivante:

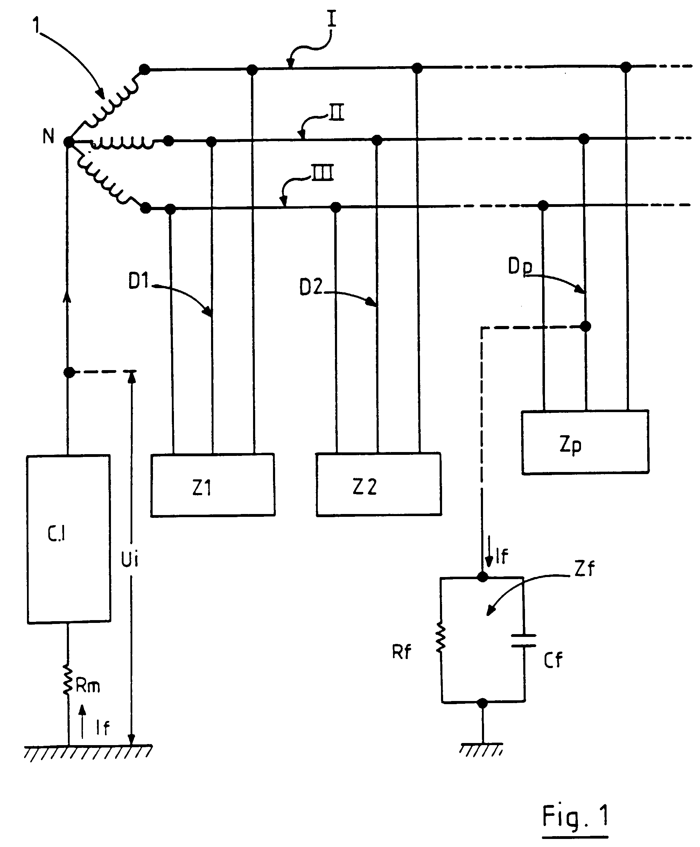

En se référant à la figure 1 représentant l'art antérieur, un transformateur d'alimentation triphasé 1, en montage étoile avec neutre isolé N, alimente en énergie électrique alternative les trois barres de distribution I,II, III du réseau ou secteur qui alimente en énergie électrique plusieurs impédances d'utilisation Z1,Z2,...,Zp,..., celles-ci étant respectivement branchées sur un même nombre de dérivations triphasées D1,D2,...,Dp,..., de ce réseau principal de distribution I,II,III.

Il est supposé qu'une des impédances de charge, par exemple l'impédance Zp, présente un défaut d'isolement par rapport à la terre qui se traduit par la présence dommageable, entre au moins un des trois fils de phase de la dérivation correspondante Dp et la terre, d'une impédance de fuite Zf constituée d'une résistance de fuite Rf en parallèle avec une capacité de fuite Cf.

Pour détecter et mesurer ce défaut, un contrôleur d'isolement C.I., qui est branché entre le neutre isolé N et la terre en série avec une résistance de mesure Rm, injecte sur le réseau d'alimentation I,II,III, une tension alternative dite "de référence", de tension Ui et de fréquence inférieure à celle du courant alternatif d'alimentation, cette fréquence injectée étant par exemple comprise entre 4 et 10 Hertz pour un réseau alternatif à 50 ou 60 Hertz.

La présence du défaut d'isolement entraîne, suite à l'injection sur le réseau de la tension de référence Ui, la circulation d'un courant de fuite If dans l'impédance de fuite Zf, ce courant If étant bien entendu à la fréquence de la tension injectée Ui et se rebouclant vers le contrôleur d'isolement C.I à travers la terre et la résistance de mesure Rm.

Le contrôleur d'isolement C.I. génère lui-même par ailleurs une sinusoïde et une cosinusoide auxiliaires qui lui permettent, par un procédé classique dit de démodulation ou détection synchrone, de déterminer les deux composantes, prises selon les mêmes axes de référence, réelle et imaginaire des vecteurs représentatifs de la tension injectée Ui et du courant de fuite If (c'est a dire en fait du courant injecté). De ces composantes, il déduit la différence de phases entre ces vecteurs Ui et If, et de là les valeurs de la résistance de fuite Rf et de la capacité de fuite Cf.

Ces contrôleurs d'isolement de l'art connu permettent de déterminer et de mesurer un défaut d'isolement se produisant quelque part sur le réseau. Il ne permettent en revanche pas de localiser ce défaut, ce qui oblige ensuite à des recherches longues et coûteuses. Par ailleurs, ils sont bien entendu incapables de déterminer s'il s'agit d'un défaut d'isolement unique, en un point déterminé du réseau, ou si au contraire on se trouve en présence de défauts d'isolements multiples.

Le document FR-A-2.647.219 se rapporte à un dispositif de contrôle et de mesure d'isolement utilisant un circuit d'injection d'une tension alternative de référence, des moyens pour la mesure du courant de fuite local parcourant les dérivations du réseau, un localisateur pour effectuer la détection synchrone du courant de fuite local grâce à deux signaux alternatifs de référence, une liaison pour transmettre au localisateur un signal d'information du circuit d'injection pour connaître la référence de phase du signal injecté sur le réseau pour le calcul des composantes résistive et capacitive du signal image d'une impédance de défaut. et par dérivation un transformateur différentiel associé à un amplificateur sélectif analogique coopérant avec un démodulateur assurant la détection de la tension de sortie en phase avec la tension de contrôle, pour produire des courants continus de signalisation inversement proportionnels aux résistances d'isolement respectives des lignes. La fréquence de la tension de contrôle est supérieure à 50 Hz. Le déphasage introduit par l'ensemble amplificateur et démodulateur, n'est pas compensé, et varie d'autre part avec la température, et d'un lot de fabrication sur l'autre. La fréquence supérieure à 50 Hz de la tension contrôle augmente l'influence de la capacité parasite de l'impédance de fuite, ladite capacité n'étant pas mesurée par le dispositif de contrôle. La transmission de l'information tension pour la détection en phase est analogique, et est donc soumise à des parasites, et à des facteurs de perturbation. L'isolement global du réseau n'est pas pris en compte par le dispositif. La précision d'un tel dispositif de contrôle d'isolement n'est pas suffisante.

L'invention vise à combiner un contrôleur d'isolement global avec un contrôleur d'isolement local. Elle se rapporte à cet effet à un dispositif de contrôle et de mesure d'isolement pour réseau électrique à neutre isolé, ayant plusieurs dérivations, ledit dispositif comportant un contrôleur d'isolement global, destiné à déterminer l'impédance de fuite du réseau, ledit contrôleur d'isolement global comprenant :

- des moyens pour générer et injecter sur le réseau un signal alternatif d'injection, ayant une fréquence inférieure à celle du courant alternatif d'alimentation du réseau,

- des moyens pour générer, de manière interne, deux signaux alternatifs de référence, déphasés l'un par rapport à l'autre de 90 degrés, et de même fréquence que ledit signal alternatif d'injection;

- des moyens pour mesurer, la tension dudit signal injecté sur le réseau, et le courant de fuite global du réseau,

- et des moyens de traitement par démodulation ou détection synchrone, faisant usage des signaux de référence pour déterminer leurs parties réelle et imaginaire par rapport à l'axe réel défini par un de ces deux signaux de référence, de façon à en déduire les composantes résistive et capacitive de l'impédance de fuite globale.

Ce dispositif se caractérisant par le fait qu'il comporte en outre:

- une installation de traitement, ou "localisateur",

- des premiers moyens formés par des transformateurs d'intensité à tores entourant chaque dérivation pour la mesure du courant de fuite local parcourant ladite dérivation par la présence du signal alternatif injecté sur le réseau, le signal de mesure délivré par chaque transformateur étant appliqué audit localisateur,

- des deuxièmes moyens du localisateur pour effectuer la démodulation ou détection synchrone du courant de fuite local dans chaque dérivation, grâce à deux autres signaux alternatifs de référence de mêmes caractéristiques que ceux générés par ledit contrôleur d'isolement global,

- et au moins deux liaisons de télétransmissions distinctes agencées entre le contrôleur d'isolement global et le localisateur, et comprenant une première liaison synchrone transmettant des impulsions de synchronisation des signaux alternatifs de référence du localisateur sur ceux du contrôleur d'isolement global, et une deuxième liaison transmettant au localisateur les valeurs démodulées du signal d'injection établies par le contrôleur d'isolement global pour le calcul des composantes de l'impédance de fuite locale dans la dérivation considérée.

De toute façon, l'invention sera bien comprise, et ses avantages et autres caractéristiques ressortiront, lors de la description suivante d'un exemple non-limitatif de réalisation de ce dispositif de contrôle d'isolement avec localisateur, en référence au dessin schématique annexé dans lequel:

- la figure 2 est un schéma synoptique d'ensemble de cette installation;

- les figures 3A à 3D sont des courbes explicatives du fonctionnement de la synchronisation effectuée, selon l'invention, entre le contrôleur global d'isolement et le localisateur;

- la figure 4 est un schéma simplifié du dispositif de mesure et correction du déphasage introduit localement pour chaque transformateur de mesure d'intensité à tore; et

- la figure 5 est un schéma simplifié d'un des dispositifs de mesure du déphasage d'une chaîne, avec mesure auxiliaire du courant à 50 Hertz, qui équipe cette installation.

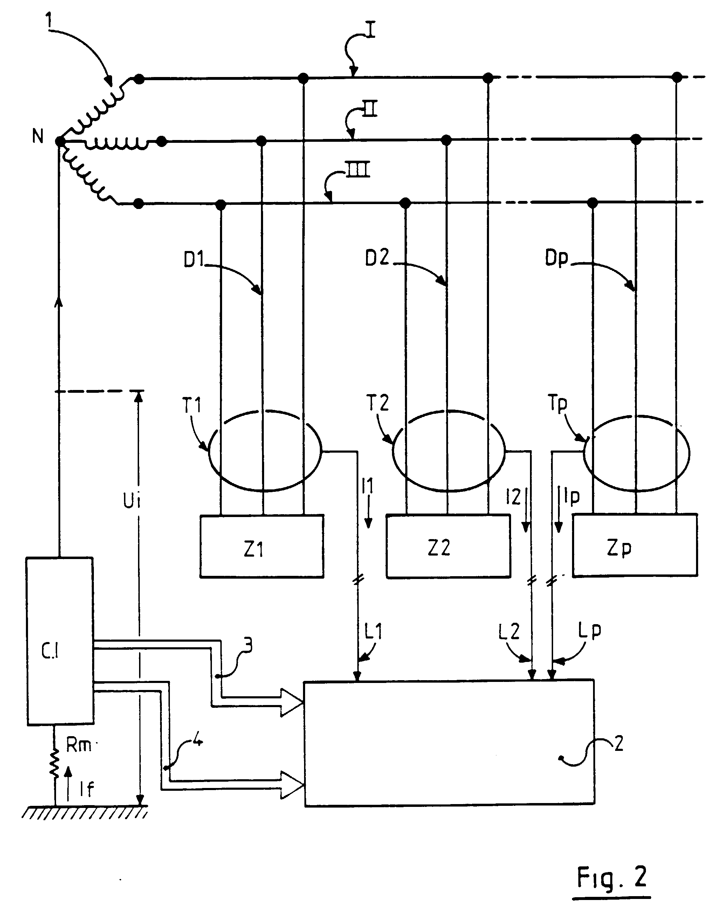

En se reportant tout d'abord à la figure 2, cette installation se différencie de celle précédemment décrite en référence à la figure 1 par le fait qu'un transformateur de mesure d'intensité à tore, respectivement T1,T2,..., Tp,..., est placé autour de chacune des dérivations précitées D1,D2,...,Dp,...Le signal de mesure d'intensité qui est délivré par chacun des transformateurs T1 à Tp est appliqué, via une ligne bifilaire L1, L2,...,Lp,..., à un ensemble de traitement et de calcul 2 que l'on appelera "localisateur".

A noter qu'en principe, si du moins le réseau d'alimentation triphasée est bien équilibré, les sorties L1,L2,...,Lp,...., des transformateurs à tore ne fournissent normalement qu'un signal à la fréquence d'injection précité, car les signaux alternatifs à 50 Hertz s'annulent. En cas de défaut d'isolement, ceci peut ne pas être réalisé et, outre des filtres rejecteurs du courant à 50 Hertz, le localisateur 2 comporte un circuit spécial de mesure du courant à 50 Hertz qui sera décrit ultérieurement.

Essentiellement, le localisateur 2 comporte un processeur central et des chaînes de mesure, d'acquisition, et de traitement numérique qui sont pratiquement identiques à celles du contrôleur global d'isolement C.I, et par exemple décrites en détails dans le document FR-A-2.647.220 précité.

Le localisateur 2 effectue la démodulation synchrone du ou des courants de mesure I1, et/ou I2,... et/ou Ip,..., qui parcourent la ou les liaisons bifilaires L1, et/ou L2,..., et/ou Lp,..., au moyen d'une sinusoïde et d'une cosinusoïde de référence générées par lui-même, et ayant la même fréquence que celles générées par le contrôleur d'isolement global C.I.

La démodulation synchrone effectuée par le localisateur 2 permet d'obtenir les composantes réelle et imaginaire du courant de fuite dans la ou les dérivations où une telle fuite existe. Le localisateur 2 permet également de localiser la dérivation dans laquelle s'est produit le défaut. Pour permettre de calculer les composantes résistive et capacitive de l'impédance de fuite dans cette dérivation, ou dans chacune de ces dérivations, le localisateur 2 doit connaître les valeurs réelle et imaginaire correspondantes (c'est à dire prises selon les mêmes axes de référence) de la tension aux bornes du défaut.

La tension aux bornes du défaut correspond en fait à la tension injectée Ui qui est la même tout le long du réseau.

Selon une caractéristique essentielle de la présente invention, le localisateur 2 utilise directement, pour le calcul des composantes de la ou des impédances de fuite dans la ou les dérivations, les données démodulées de la tension d'injection Ui qui ont été préalablement calculées, par mesure et par démodulation synchrone, dans le contrôleur d'isolement global C.I. Dans ce but, deux liaisons de télétransmission distinctes sont prévues entre le contrôleur d'isolement C.I et le localisateur 2:

- une première liaison 3, qui est nécessairement une liaison de type synchrone, et qui transmet des impulsions fixes de synchronisation de la sinusoïde de référence élaborée par le contrôleur d'isolement C.I.

- une seconde liaison 4, qui peut être une liaison asynchrone, et qui transmet au localisateur 2 les valeurs démodulées de la tension d'injection Ui qui sont établies par le contrôleur C.I.

A noter que cette mise en phase, ou synchronisation, des deux sinusoïdes de référence respectivement élaborées par le contrôleur C.I et le localisateur 2 est indispensable à la détermination des composantes des impédances locales de fuite, puisque cette détermination nécessite la connaissance des composantes réelle et imaginaire de la tension et du courant aux bornes de chaque impédance de fuite, ces composantes étant nécessairement déterminées par rapport aux mêmes axes de référence.

En se reportant pour plus de clarté aux diagrammes 3A à 3D, il est représenté:

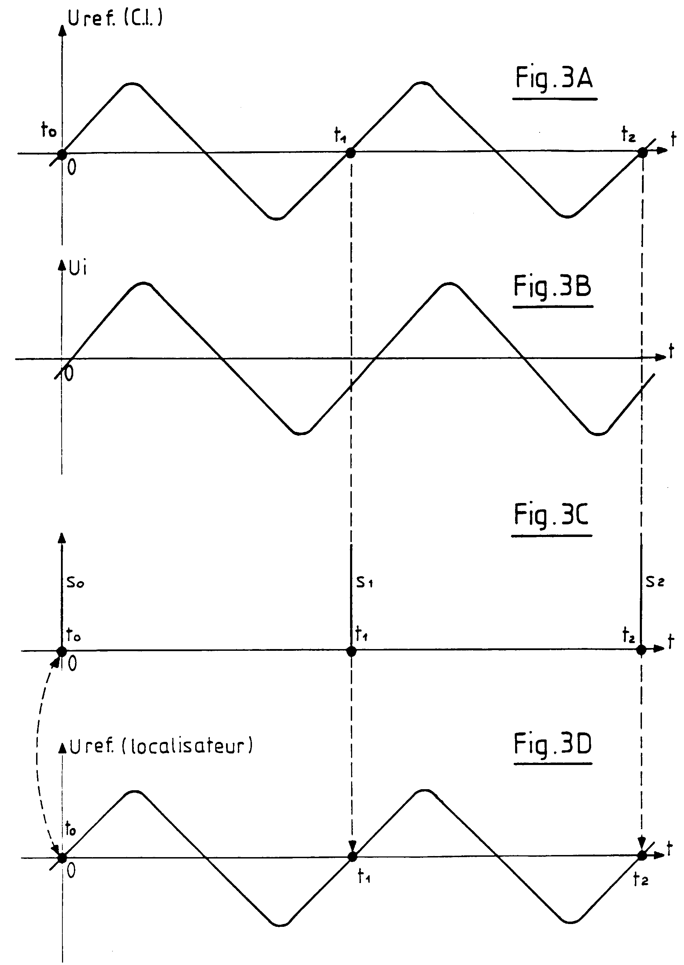

- sur la figure 3A la sinusoïde de référence à fréquence comprise entre 4 et 10 Hertz, qui est élaborée, par exemple de la manière décrite dans le document FR-A-2.647.220, de façon interne par le contrôleur global d'isolement C.I, et qui lui sert, d'une part à effectuer la démodulation synchrone du courant de fuite mesuré If et de la tension injectée Ui, et d'autre part à l'élaboration de cette tension injectée Ui proprement dite.

- sur la figure 3B, la tension injectée Ui a subi un déphasage par rapport à la tension de référence de la figure 3A. Le déphasage est dû à la présence d'un filtre d'injection comportant en particulier un circuit bouchon accordé sur la fréquence 50 Hertz du réseau. Pour obtenir la différence de phase $\varphi$ entre la tension injectée Ui et le courant de fuite If, il est nécessaire de réaliser une démodulation synchrone permettant de déterminer les phases $\varphi 2$ et $\varphi 1$ des vecteurs représentatifs de Ui et If par rapport à un axe de référence. Le calcul du déphasage recherché s'opère par la relation : $\varphi = \varphi 2 - \varphi 1$.

- sur la figure 3C, les impulsions ou "tops", de synchronisation s0,s1,s2,..., sont élaborées par le contrôleur d'isolement C.I. et transmis au localisateur 2 via le bus de liaison synchrone 3 à chaque passage par zéro en début de chaque alternance de la tension de référence du contrôleur C.I, intervenant aux instants t0,t1,t2,...

- et finalement en figure 3D la sinusoïde de référence, identique à celle selon la figure 3A, qui est élaborée par le localisateur 2 et utilisée de façon interne pour effectuer la démodulation synchrone du ou des courants locaux précités I1,I2,...,Ip. Comme schématisé par les flèches en pointillés, cette sinusoïde est synchronisée par les tops s0,s1,s2,..., selon la figure 3C, de façon à ce que ses instants de passage à zéro en début de chaque alternance soient les instants t0,t1,t2,..., précités, de sorte que finalement cette sinusoïde de référence du localisateur est précisément en phase avec celle (figure 3A) du contrôleur d'isolement global C.I.

En revenant maintenant au schéma synoptique d'ensemble de la figure 2, on a vu que chacun des courants locaux de mesure I1,I2,..., Ip,..., était déterminé au moyen d'un transformateur de mesure T1,T2,...,Tp,... Or, un tel transformateur de mesure à tore est un élément selfique qui introduit un déphasage propre $\varphi$ de la forme:

$$\varphi = \text{Arc tg . R/lw}$$

où R et l sont les résistance et inductance propre de l'enroulement du tore, et w est la pulsation du courant de mesure à fréquence comprise entre 4 et 10 hertz.

Conformément à une caractéristique avantageuse de l'invention, des moyens sont prévus au niveau du localisateur 2 pour mesurer, de temps à autre, les valeurs de R et l de chaque tore pour en déduire le déphasage correspondant $\varphi$, afin d'en tenir compte lors du calcul d'impédance(s) de fuite effectué par le localisateur 2.

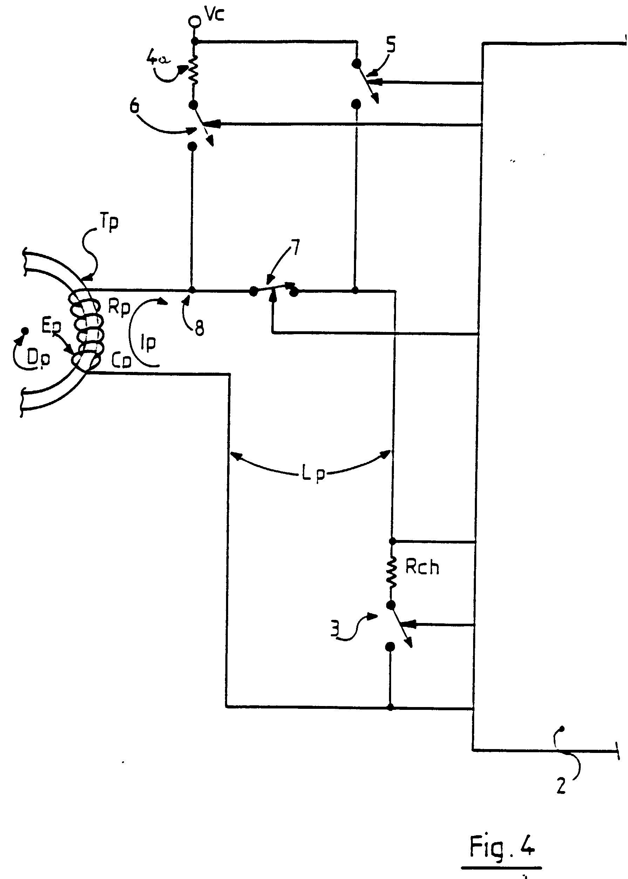

Ces moyens sont représentés schématiquement sur la figure 4, appliqués au tore Tp par exemple. Bien entendu, ils sont identiques pour chacun des autres tores de cette installation. Sur cette figure 4, le tore Tp est muni d'un enroulement secondaire Ep qui est parcouru par le courant de mesure Ip précité, et qui présente une résistance et une self propres Rp et lp. Les trois barres ou conducteurs de dérivation Dp ont été symboliquement représentées par une seule barre.

Afin d'effectuer une correction relative au déphasage parasite introduit par le tore Tp, le localisateur 2 a besoin de connaître les valeurs de Rp et de lp.

La mesure de la self lp s'effectue de manière très simple, et par un procédé similaire à celui décrit dans le document FR-A-2.647.219 de la demanderesse, en prévoyant la possibilité de brancher, grâce à un interrupteur statique 3 commandé par le localisateur 2, une résistance de charge Rch aux bornes de l'enroulement Ep du transformateur Tp.

Lorsque l'interrupteur statique 3 est ouvert, la tension "à vide" qui est mesurée par le localisateur 2 aux bornes des deux fils Lp est de la forme:

$$(I) : V \text{ (à vide)} = lw/Np \cdot lp$$

où Np est le nombre de tours de l'enroulement Ep.

Lorsque l'interrupteur 3 est fermé, la tension "en charge" qui est mesurée de la même façon par le localisateur 2 est de la forme:

$$(II) : V \text{ (en charge)} = Rch/Np \cdot lp$$

Le localisateur 2 déduit aisément des deux équations (I) et (II) la valeur recherchée de la self 1.

La mesure de la résistance Rp de l'enroulement Ep est une mesure potentiométrique utilisant une tension continue auxiliaire Vc et une résistance auxiliaire (4a) qui est apte à être branchée en série avec l'enroulement Ep de manière à réaliser, un montage potentiométrique. En outre, trois autres interrupteurs statiques commandés par le localisateur 2 sont prévus, dont:

- un interrupteur 5 destiné à relier directement la borne de tension continue Vc au localisateur 2, afin que ce dernier puisse en effectuer la mesure;

- un interrupteur 6 apte à appliquer la tension VC à l'enroulement Ep à travers la résistance de mesure potentiomètrique 4; et

- un interrupteur 7 placé sur la liaison Lp entre les interrupteurs 6 et 5 et apte, lorsqu'il est ouvert en même temps que l'est l'interrupteur 6, à permettre de relier sélectivement, via l'interrupteur 5 alors fermé, la borne de tension Vc au localisateur 2.

Dans l'état ouvert de l'interrupteur 3, la mesure de la résistance Rp s'effectue de la façon suivante:

- les interrupteurs 6 et 7 étant ouverts et l'interrupteur 5 fermé, le localisateur 2 mesure la valeur de la tension continue auxiliaire Vc;

- puis, avec l'interrupteur 5 ouvert et les interrupteurs 6 et 7 fermés, il mesure la valeur de la tension continue Vc au point 8 commun aux deux résistances (4a) et Rp;

- il calcule alors la valeur de la résistance Rp par application de la formule:

$$Uc = V_c \times R_p/(R_p + R_4)$$

où R4 est la valeur connue de la résistance (4a)

A noter que la mesure du déphasage de chaque tore par la méthode qui vient d'être décrite n'a pas besoin d'être effectuée à fréquence répétitive élevée, mais de temps à autre, compte tenu des variations possibles relativement lentes des valeurs mesurées. A noter également que ce même dispositif permet aussi de détecter la présence ou l'absence d'un tore de mesure dans la dérivation considérée.

En revenant à nouveau au schéma général de la figure 2, on a vu que le contrôleur global d'isolement (C. I.) effectue la démodulation synchrone de la tension injectée Ui et du courant de fuite If, tandis que le localisateur 2 n'effectue que la démodulation synchrone des courants de mesure l1,l2,... ,lp. Les chaînes de mesure utilisées sont pratiquement identiques, mais du fait de la présence d'un filtre passe-bas réjecteur du courant à 50 hertz, elles introduisent des déphasages différents, qu'il convient donc de compenser. Dans le cas des contrôleurs d'isolement de l'art antérieur, n'ayant pas de localisateur, cette compensation était automatique puisque la mesure de la différence de phase entre Ui et If, s'effectue par soustraction des phases respectives. Tel n'est plus le cas pour le localisateur 2 selon l'invention, puisque ce localisateur utilise, d'une part une mesure directe du courant local l1,l2,...,lp, et d'autre part la mesure de Ui qui a été effectuée, avec la chaîne de mesure propre du contrôleur C.I.

Conformément à une autre caractéristique de l'invention, le contrôleur global d'isolement C.I. comporte des moyens destinés à mesurer, de temps à autre, le déphasage propre introduit par la chaîne de mesure de la tension d'injection Ui, et à tenir compte de ce déphasage dans le calcul des valeurs démodulées de cette tension Ui qui sont transmises, via la liaison 4, au localisateur 2.

Le localisateur 2 comprend des moyens pour mesurer, également de temps à autre le déphasage propre introduit par la ou les chaînes de mesure de courant de mesure local l1,l2,...,lp, et pour là aussi tenir compte de ce déphasage dans le calcul des valeurs démodulées de ce ou ces courants de mesure.

Dans l'un et l'autre cas, cette mesure du déphasage de chaque chaîne de mesure s'effectue en injectant dans cette chaîne la tension de référence qui est générée localement (respectivement par le contrôleur C.I. et par le localisateur 2) pour effectuer la ou les démodulations synchrones, et en effectuant alors la démodulation synchrone du signal alors reçu en fin de chaîne par rapport à celui ainsi injecté dans cette chaîne, de manière à en déduire le déphasage propre de la chaîne. L'organe de traitement du contrôleur C.I. et du localisateur 2 respectivement, stocke alors la valeur de ce déphasage propre, de façon à pouvoir le déduire des mesures de déphasages ultérieures.

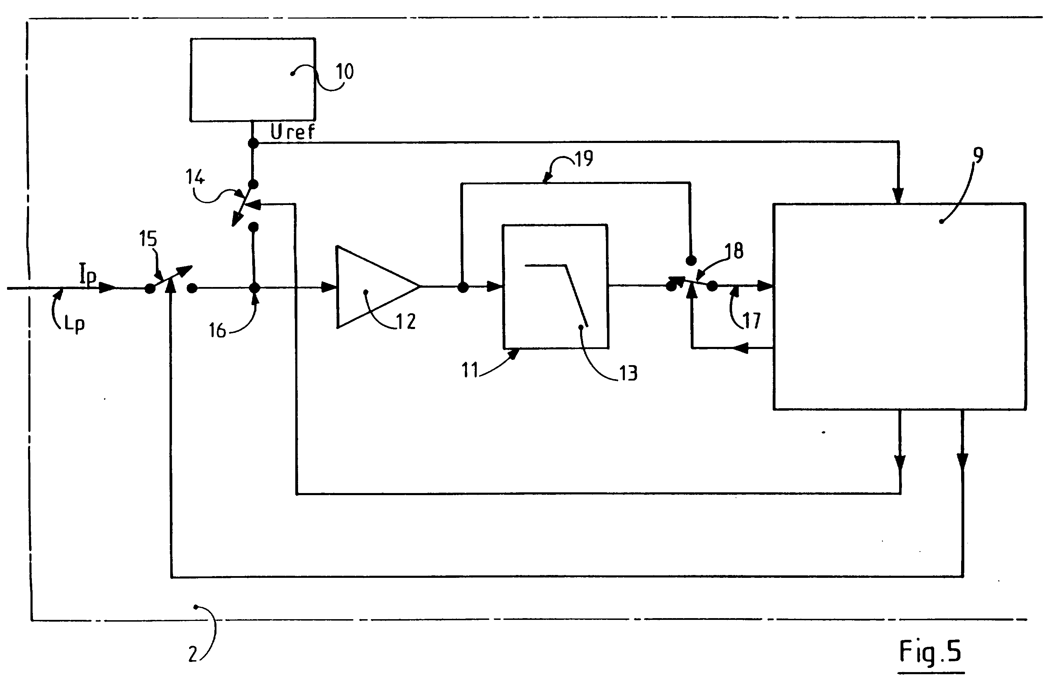

La figure 5 est un schéma de principe d'un tel circuit de mesure du déphasage propre, tel qu'appliqué dans cet exemple à une chaîne de mesure du localisateur 2, étant bien entendu que le schéma relatif au circuit qui équipe le contrôleur C.I. est pratiquement le même.

Sur la figure 5, quelques éléments du localisateur 2 on été figurés, dont:

- l'organe interne de traitement 9;

- l'organe interne 10 d'élaboration de la tension de référence Uref qui est utilisée par l'organe 9 pour effectuer la démodulation synchrone du ou des courants de mesure Ip;

- la chaîne de mesure 11, partiellement représentée avec son amplificateur à grand gain 12 suivi de son filtre passe-bas 13 de réjection du courant à 50 hertz.

Conformément au moyen de mesure précité, il est en outre prévu la possibilité, de temps à autre, d'isoler, au moyen d'un premier interrupteur statique 15 commandé par l'organe de traitement 9, la chaîne de mesure 11 de la ligne de mesure Lp, et de connecter alors l'entrée 16 de cette chaîne, via un autre interrupteur statique 14 lui aussi commandé par l'organe 9, à la sortie du circuit 10 délivrant la tension de référence Uref.

L'organe 9 effectue alors la démodulation synchrone de la tension ainsi obtenu en fin de chaîne, au point référencé 17, et la compare à la tension Uref en sortie du circuit 10 pour en déduire le déphasage propre à la chaîne 11. IL peut ainsi ensuite déduire ce déphasage des mesures ultérieures du ou des courants Ip qui seront obtenus après rebasculement des interrupteurs 14 et 15.

Bien entendu, la chaîne de mesure du contrôleur C. I. est équipée d'un dispositif identique pour mesurer localement et de façon interne le déphasage engendré par sa propre chaîne de mesure.

Enfin, il convient de remarquer qu'il a été jusqu'à présent fait hypothèse que les trois phases de dérivations D1,D2,...,Dp, étaient bien équilibrées, de sorte que les courants à 50 Hertz étaient pratiquement inexistants dans les lignes de mesure L1,L2,...,Lp,...Toutefois dans le cas d'un défaut d'isolement résistif, un courant à 50 Hertz risque de circuler entre la phase en défaut et la somme des capacités parasites présentes sur les deux autres phases. La valeur d'un tel courant peut parfois dépasser un ampère. Ce courant à 50 Hertz peut alors saturer l'amplificateur 12 de la chaîne de mesure 11 (figure 5), ce qui rend impossible la mesure du courant II par exemple.

Conformément à l'invention, et pour rémédier à cet inconvénient, deux dispositions supplémentaires sont préférentiellement adoptées:

- La ou les chaînes de mesure 11 du localisateur sont agencées pour supporter un courant de seuil prédéfini, par exemple de 500 milliampères. On constate en effet, grâce à un relevé des courbes, que la résistance de défaut est limitée à une valeur fixe quelle que soit la capacité parasite équivalente. Pour un réseau à 380 volts par exemple, la résistance de défaut reste inférieure à 450 ohms environ tant que le courant de défaut reste inférieur à 500mA.

- Des moyens sont prévus pour mesurer, de temps à autre, l'amplitude du courant à 50 Hertz présent à l'entrée ou en amont du filtre-réjecteur 13 de la chaîne de mesure, pour signaler le dépassement du seuil précité à l'utilisateur afin de l'avertir de la présence d'un défaut franc dans la dérivation Dp considérée sur la figure 5, ces derniers moyens comprennent un commutateur statique à deux voies 18, qui est commandé par l'organe de traitement 9 et qui, placé comme représenté entre le filtre 13 et cet organe 9, permet, grâce à la dérivation 19, de court-circuiter de temps à autre ce filtre 13 pour effectuer la mesure du courant à 50 Hertz. En cas de dépassement du seuil, l'usager est prévenu par exemple par une alarme déclenchée par l'organe de traitement 9, et permettant aussi de localiser le défaut franc.

Comme il va de soi, l'invention n'est nullement limitée à l'exemple de réalisation qui vient d'être décrit. En particulier, il pourra avantageusement être prévu dans le localisateur 2, afin de réduire le nombre de chaînes de mesure 11, un dispositif de multiplexage permettant d'utiliser une même chaîne pour plusieurs tores de mesure.

**Revendications**

1. Dispositif de contrôle et de mesure d'isolement pour réseau électrique (I, II, III) à neutre isolé (N), ayant plusieurs dérivations (D1,D2,...,Dp,...), ledit dispositif comportant un contrôleur d'isolement global (C. I.), destiné à déterminer l'impédance de fuite du réseau, ledit contrôleur d'isolement global (C.I.) comprenant :

   - des moyens pour générer et injecter sur le réseau (I,II,III) un signal alternatif d'injection (Ui), ayant une fréquence inférieure à celle du courant alternatif d'alimentation du réseau,

   - des moyens pour générer, de manière interne, deux signaux alternatifs de référence (Uref), déphasés l'un par rapport à l'autre de 90 degrés, et de même fréquence que ledit signal alternatif d'injection (Ui);

   - des moyens pour mesurer la tension (Ui) dudit signal injecté sur le réseau, et le courant de fuite global (If) du réseau,

   - et des moyens de traitement par démodulation ou détection synchrone, faisant usage des signaux de référence (Uref) pour déterminer leurs parties réelle et imaginaire par rapport à l'axe réel défini par un de ces deux signaux de référence (Uref), de façon à en déduire les composantes résistive et capacitive de l'impédance de fuite globale,

caractérisé en ce que le dispositif de contrôle comporte en outre :

- une installation de traitement, ou "localisateur" (2),

- des premiers moyens formés par des transformateurs d'intensité (T1,T2,..,Tp) à tores entourant chaque dérivation (D1, D2...Dp) pour la mesure du courant de fuite local parcourant ladite dérivation par la présence du signal alternatif (Ui) injecté sur le réseau, le signal de mesure ($I_1, I_2, ..., I_p$) délivré par chaque transformateur étant appliqué audit localisateur,

- des deuxièmes moyens du localisateur (2) pour effectuer, la démodulation ou détection synchrone du courant de fuite local (l1,l2,...,lp,) dans chaque dérivation (D1,D2,...,Dp), grâce à deux autres signaux alternatifs de référence de mêmes caractéristiques que ceux (Uref) générés par ledit contrôleur d'isolement global (C.I.),

- et au moins deux liaisons de télétransmissions distinctes agencées entre le contrôleur d'isolement global (C.I.) et le localisateur (2), et comprenant une première liaison synchrone (3) transmettant des impulsions (s0,s1,s2,...) de synchronisation des signaux alternatifs de référence du localisateur (2) sur ceux du contrôleur d'isolement global (C.I.) , et une deuxième liaison (4) transmettant au localisateur (2) les valeurs démodulées du signal d'injection (Ui) établies par le contrôleur d'isolement global (C.I.) pour le calcul des composantes de l'impédance de fuite locale dans la dérivation considérée (Dp).

2. Dispositif selon la revendication 1, caractérisé en ce que l'enroulement secondaire (Ep) de chaque transformateur (T1, T2...Tn) est associé à des troisièmes moyens de mesure de la résistance (Rp) et de la self-inductance (lp) dudit enroulement secondaire (Ep), lesdits troisièmes moyens de mesure étant agencés selon un circuit de mesure potentiométrique comportant une résistance auxiliaire (4a) branchée, par l'intermédiaire d'un premier interrupteur (6), entre une source de tension continue auxiliaire (Vc) et un point commun (8) connecté à une borne de l'enroulement secondaire (Ep), et une résistance de charge (Rch) dont la première extrémité est connectée au point commun (8) par un deuxième interrupteur (7) et à ladite source de tension auxiliaire (Vc) par un quatrième interrupteur (5) et à une première entrée du localisateur (2) et dont la seconde extrémité est connectée par un troisième interrupteur (3) à la seconde entrée du localisateur (2) et à l'autre borne de l'enroulement secondaire (Ep) , lesdits interrupteurs (3,5,6,7) étant pilotés à partir du localisateur (2) pour effectuer la correction relative au déphasage parasite introduit par chaque transformateur (T1, T2,...Tn).

3. Dispositif selon la revendication 1 ou 2, caractérisé en ce qu'il comporte en outre:

- des quatrièmes moyens agencés dans le contrôleur global d'isolement (C.I.) pour mesurer le déphasage propre introduit par la chaîne de mesure de la tension injectée (Ui), et pour tenir compte de ce déphasage dans le calcul des valeurs démodulées de cette tension qui sont transmises, via la deuxième liaison (4) au localisateur (2);

- des cinquièmes moyens (10, 9,14 à 16) agencés dans le localisateur (2) pour mesurer le déphasage propre introduit par la ou les chaînes de mesure (11) de courant de fuite local (l1,l2,...,lp,...), ledit déphasage étant pris en compte dans le calcul des valeurs démodulées du courant de fuite locale (l1,l2,...,lp,...).

4. Dispositif selon l'une des revendications 1 à 3, caractérisé en ce que la ou chacune de ces chaînes de mesure (11) du localisateur (2)comporte un filtre-réjecteur et des sixièmes moyens (18,19,9) pour mesurer l'amplitude du courant à fréquence secteur qui est présent en amont dudit filtre-réjecteur (13) pour avertir l'usager de la présence d'un défaut franc dans la dérivation (Dp) considérée, lesdits sixièmes moyens comprenant un commutateur statique (18) commandé par un organe de traitement (9) du localisateur (2) et permettant, grâce à une liaison de dérivation (19), de court-circuiter de temps à autre le filtre-réjecteur (13) pour effectuer ladite mesure du courant à la fréquence secteur.

**Patentansprüche**

1. Isolationsüberwachungs- und -meßeinrichtung für ein elektrisches Leitungsnetz (I, II, III) mit isoliertem Sternpunkt (N) und mehreren Abgängen (D1, D2, ..., Dp, ...), wobei die genannte Einrichtung einen Gesamt-Isolationswächter (C.I.) zur Bestimmung der Fehlerimpedanz des Netzes aufweist, der folgende Teile umfaßt:

- Mittel zur Erzeugung und Beaufschlagung des Netzes mit einem Wechselspannungs-Prüfsignal (Ui), dessen Frequenz unter der Frequenz des zur Netzeinspeisung verwendeten Wechselstroms liegt,

- Mittel zur internen Erzeugung von zwei Wechselspannungs-Referenzsignalen (Uref), die um 90 Grad gegeneinander phasenverschoben sind und die gleiche Frequenz aufweisen wie das genannte Wechselspannungs-Prüfsignal (Ui),

- Mittel zur Messung der Spannung (Ui) des genannten, in das Netz injizierten Prüfsignals sowie des Gesamtfehlerstroms (If) des Netzes

- und Mittel zur Signalverarbeitung durch synchrone Demodulation oder Erfassung unter Verwendung der Referenzsignale (Uref), um deren Real- und Imaginärteil in bezug auf die reelle, durch eines der beiden Referenzsignale (Uref) definierte Achse zu bestimmen und daraus die Wirk- und Blindanteile der Gesamt-Fehlerimpedanz abzuleiten,

dadurch gekennzeichnet, daß die Überwachungseinrichtung darüber hinaus folgende Komponenten umfaßt:

- eine als "Fehlerorter" (2) bezeichnete Verarbeitungsschaltung,

- durch um jeden Abgang (D1, D2, ..., Dp) gelegte Ringkern-Stromwandler (T1, T2, ..., Tp) gebildete erste Mittel zur Messung des im genannten Abgang aufgrund des in das Netz injizierten Wechselspannungssignals (Ui) fließenden örtlichen Fehlerstroms, wobei das von jedem Stromwandler gelieferte Meßsignal (I1, I2 ..., Ip) den genannten Fehlerorter beaufschlagt,

- zweite Mittel des Fehlerorters (2) zur Durchführung der synchronen Demodulation oder Erfassung des örtlichen Fehlerstroms (I1, I2 ..., Ip) in jedem Abgang (D1, D2, ..., Dp) mit Hilfe von zwei weiteren Wechselspannungs-Referenzsignalen, deren Kenngrößen mit denen der durch den genannten Gesamt-Isolationswächter (C.I.) erzeugten Referenzsignale (Uref) übereinstimmen, und

- mindestens zwei, zwischen den Gesamt-Isolationswächter (C.I.) und den Fehlerorter (2) geschaltete, getrennte Fernübertragungsverbindungen, welche eine erste Synchronverbindung (3) für die Übertragung der Impulse (s0, s1, s2, ...) zur Synchronisierung der Wechselspannungs-Referenzsignale des Fehlerorters (2) mit den Referenzsignalen des Gesamt-Isolationswächters (C.I.) sowie eine zweite Verbindung (4) umfassen, die zur Berechnung der Einzelkomponenten der örtlichen Fehlerimpedanz im jeweiligen Abgang (Dp) die vom Gesamt-Isolationswächter (C.I.) erzeugten demodulierten Werte des injizierten Signals (Ui) an den Fehlerorter (2) überträgt.

2. Einrichtung nach Anspruch 1, dadurch gekennzeichnet, daß die Sekundärwicklung Ep jedes Stromwandlers (T1, T2, ..., Tn) dritten Mitteln zur Messung des ohmschen Widerstands (Rp) und der Induktivität (lp) der genannten Sekundärwicklung (Ep) zugeordnet ist, wobei die genannten dritten Meßmittel als Spannungsteiler-Meßschaltung ausgeführt sind, die einen, über einen ersten Schalter (6) zwischen eine Hilfs-Gleichspannungsquelle (Vc) und einen, an eine Klemme der Sekundärwicklung (Ep) angeschlossenen gemeinsamen Punkt (8) geschalteten Hilfswiderstand (4a) sowie einen Lastwiderstand (Rch) umfaßt, dessen erster Anschluß über einen zweiten Schalter (7) mit dem gemeinsamen Punkt (8) und über einen vierten Schalter (5) mit der genannten Hilfs-Gleichspannungsquelle (Vc) sowie mit einem ersten Eingang des Fehlerorters (2) verbunden und dessen zweiter Anschluß über einen dritten Schalter (3) an den zweiten Eingang des Fehlerorters (2) sowie an die andere Klemme der Sekundärwicklung (Ep) angeschlossen ist, wobei die genannten Schalter (3, 5, 6, 7) über den Fehlerorter (2) angesteuert werden, um die durch die Streuinduktivität jedes Stromwandlers (T1, T2, ..., Tn) verursachte Phasenverschiebung zu kompensieren.

3. Einrichtung nach Anspruch 1 oder 2, dadurch gekennzeichnet, daß sie zusätzlich folgende Teile umfaßt:

- im Gesamt-Isolationswächter (C.I.) angeordnete vierte Mittel zur Messung der durch den Meßzweig zur Erfassung der injizierten Spannung (Ui) verursachten Eigen-Phasenverschiebung sowie zur Berücksichtigung dieser Phasenverschiebung bei der Berechnung der demodulierten Werte dieser Spannung, welche über die zweite Verbindung (4) an den Fehlerorter (2) übermittelt werden,

- im Fehlerorter (2) angeordnete fünfte Mittel (10, 9, 14 bis 16) zur Messung der durch den Meßzweig bzw. die Meßzweige (11) zur Erfassung des örtlichen Fehlerstroms (I1, I2 ..., Ip) verursachten Eigen-Phasenverschiebung, wobei diese Phasenverschiebung bei der Berechnung der demodulierten Werte des örtlichen Fehlerstroms (I1, I2, ..., Ip) berücksichtigt werden.

4. Einrichtung nach einem der Ansprüche 1 bis 3, dadurch gekennzeichnet, daß der Meßzweig bzw. jeder der Meßzweige (11) des Fehlerorters (2) ein Sperrfilter sowie sechste Mittel (18, 19, 9) zur Messung der Amplitude des auf der Einspeiseseite des genannten Sperrfilters (13) anliegenden netzfrequenten Stroms umfaßt, um dem Betreiber das Vorliegen eines satten Isolationsfehlers im betreffenden Abgang (Dp) anzuzeigen, wobei die genannten sechsten Mittel einen elektronischen Schalter (18) umfassen, der über eine Verarbeitungsschaltung (9) des Fehlerorters (2) angesteuert wird und es mit Hilfe einer Umgehungsverbindung (19) ermöglicht, das Sperrfilter (13) in größeren Zeitabständen kurzzuschließen, um die genannte Messung des netzfrequenten Stroms durchzuführen.

**Claims**

1. A device for monitoring and measuring isolation for an electrical power supply system (I, II, III) with isolated neutral (N), having several feeders (D1, D2,..., Dp,...) said device comprising an overall isolation monitor (C.I.), designed to determine the leakage impedance of the power system, said overall isolation monitor (C.I.) comprising :

   - means for generating and inputting to the power system (I, II, III) an input A.C. signal (Ui), having a frequency lower than that of the AC current supplying the power system;

   - means for generating, internally, two reference A.C. signals (Uref), with a phase difference of 90 degrees with respect to one another, of the same frequency as said input A.C. signal (Ui),

   - means for measuring the voltage (Ui) of said signal input to the power supply system, and the overall leakage current (If) of the power supply system,

   - and means for processing by synchronous demodulation or detection, using the reference signals (Uref) to determine their real and imaginary parts with respect to the real axis defined by one of these two reference signals (Uref), so as to deduce therefrom the resistive and capacitive components of the overall leakage impedance,

   characterized in that the monitoring device comprises in addition :

   - a processing installation, or "locator" (2),

   - first means formed by toroid current transformers (T1, T2,..., Tp) surrounding each feeder (D1, D2,..., Dp) for measuring the local leakage current flowing in said feeder by the presence of the A.C. signal (Ui) input to the power supply system, the measuring signal (I1, I2, ..., Ip) delivered by each transformer being applied to said locator,

   - second means of the locator (2) for performing synchronous demodulation or detection of the local leakage current (I1, I2, ..., Ip) in each feeder (D1, D2, ..., Dp), by means of two other reference AC signals having the same characteristics as those (Uref) generated by said overall isolation monitor (C.I.),

   - and at least two distinct remote transmission lines arranged between the overall isolation monitor (C.I.) and the locator (2), and comprising a first synchronous line (3) transmitting synchronization pulses (s0, s1, s2, ...) of the reference A.C. signals of the locator (2) on those of the overall isolation monitor (C.I.); and a second line (4) transmitting to the locator (2) the demodulated values of the input signal (Ui) established by the overall isolation monitor (C.I.) for computation of the local leakage impedance in the feeder involved (Dp).

2. The device according to claim 1, characterized in that the secondary winding (Ep) of each transformer (T1, T2,..., Tn) is associated to third means for measuring the resistance (Rp) and self-inductance (Ip) of said secondary winding (Ep), said third measuring means being arranged as a potentiometric measuring circuit comprising an auxiliary resistance (4a) connected by means of a first switch (6) between an auxiliary DC voltage source (Vc) and a common point (8) connected to a terminal of the secondary winding (Ep), and a charging resistance (Rch) whose first end is connected to the common point (8) by a second switch (7) and to said auxiliary voltage source (Vc) by a fourth switch (5) and to a first input of the locator (2) and whose second end is connected by a third switch (3) to the second input of the locator (2) and to the other terminal of the secondary winding (Ep), said switches (3, 5, 6, 7) being controlled from the locator (2) to perform the correction relative to the stray phase shift introduced by each transformer (T1, T2, ...Tn).

3. The device according to claim 1 or 2, characterized in that it comprises in addition :

   - fourth means arranged in the overall isolation monitor (C.I.) for measuring the phase shift proper introduced by the measuring channel of the input voltage (Ui), and to take account of this phase shift in computing the demodulated values of this voltage which are transmitted, via the second line (4), to the locator (2);

- fifth means (10, 9, 14 to 16) arranged in the locator (2) for measuring the phase shift proper introduced by the measuring channel or channels (11) of the local leakage current (I1, I2,..., Ip,...), said phase shift being taken into account in computing the demodulated values of the local leakage current (I1, I2,...,Ip,...).

4. The device according to one of the claims 1 to 3, characterized in that the measuring channel or each of the measuring channels (11) of the locator (2) comprises a rejector filter (13) and sixth means (18, 19, 9) for measuring the amplitude of the current at mains power supply frequency which is present upline from said rejector filter (13) to inform the user of the presence of a clean fault in the feeder (Dp) involved, said sixth means comprising a static switch (18) controlled by a processing unit (9) of the locator (2) and enabling the rejector filter (13) to be shortcircuited from time to time, by means of a feeder line (19), to perform said measuring of the current at power supply system frequency.

Fig. 1

Fig. 2

Uref. (C.I.)

Fig. 3A

Ui

Fig. 3B

Fig. 3C

Uref. (localisateur)

Fig. 3D

Fig.4

Fig.5

EP 0 518 785 B1